(19) Europäisches Patentamt
European Patent Office
Office européen des brevets

(11) **EP 2 640 960 B1**

(12) **EUROPÄISCHE PATENTSCHRIFT**

(45) Veröffentlichungstag und Bekanntmachung des Hinweises auf die Patenterteilung:
**11.01.2017** **Patentblatt 2017/02**

(21) Anmeldenummer: **11782631.3**

(22) Anmeldetag: **17.11.2011**

(51) Int Cl.:
**F02N 11/08** *(2006.01)*

(86) Internationale Anmeldenummer:
**PCT/EP2011/070321**

(87) Internationale Veröffentlichungsnummer:
**WO 2012/066064 (24.05.2012 Gazette 2012/21)**

(54) **VORRICHTUNG UND VERFAHREN ZUR BESTIMMUNG DER STARTFÄHIGKEIT EINES VERBRENNUNGSMOTORS**

DEVICE AND METHOD FOR DETERMINING THE STARTING CAPABILITY OF AN INTERNAL COMBUSTION ENGINE

DISPOSITIF ET PROCÉDÉ SERVANT À DÉTERMINER L'APTITUDE AU DÉMARRAGE D'UN MOTEUR À COMBUSTION INTERNE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.11.2010 DE 102010044060**

(43) Veröffentlichungstag der Anmeldung:
**25.09.2013 Patentblatt 2013/39**

(73) Patentinhaber: **Continental Automotive GmbH 30165 Hannover (DE)**

(72) Erfinder:
• **SCHRAMME, Martin**
  **86343 Königsbrunn (DE)**
• **GERING, Horst**
  **81543 München (DE)**

• **WEIGERT, Wolfgang**
  **93105 Tegernheim (DE)**
• **MÜNCH, Matthias**
  **93096 Köfering (DE)**
• **KLEMENT, Thomas**
  **93059 Regensburg (DE)**
• **GRAF, Hans-Michael**
  **93049 Regensburg (DE)**
• **TENDLER, Reinhard**
  **93080 Großberg (Pentling) (DE)**
• **FRIEDRICHSOHN, Oliver**
  **93049 Regensburg (DE)**

(56) Entgegenhaltungen:
**EP-A1- 2 138 711        US-A1- 2006 232 277
US-A1- 2008 215 266     US-A1- 2010 269 776**

EP 2 640 960 B1

**Beschreibung**

Die vorliegende Erfindung betrifft eine Vorrichtung und ein Verfahren zur Bestimmung der Startfähigkeit eines Verbrennungsmotors.

Fahrzeuge mit klassischem Verbrennungsmotor benötigen zur Stabilisierung der Bordnetzspannung und zum Starten des Verbrennungsmotors eine Batterie. Dies ist im Großteil aller Fahrzeuge eine Blei-Säure-Batterie, welche verschiedenste Ausprägungen umfassen kann.

Siehe zum Beispiel US2008/0215266. Während der Fahrt wird diese Batterie mittels eines von einem Verbrennungsmotor angetriebenen Generators (auf)geladen, während des Stillstandes des Verbrennungsmotors wird die Batterie bei angeschlossenem Verbraucher entladen. Wird die Batterie während des Stillstandes zu stark entladen, so kann dies dazu führen, dass ein Start des Verbrennungsmotors nicht mehr möglich ist.

Im Rahmen der Senkung des CO2-Ausstoßes soll nun der Verbrennungsmotor bei stehendem Fahrzeug (z.B. an der Ampel) komplett abgeschaltet werden und die Batterie, insbesondere im Schubbetrieb des Verbrennungsmotors, durch den Generator geladen werden. Diese Strategie führt tendenziell zu einer Verschärfung des Risikos für eine negative Ladebilanz der Batterie, welche im Extremfall zum Liegenbleiben, also nicht Starten, des Fahrzeuges führen kann.

Im Vergleich zur Diagnose stationärer Batterien (z.B. Stützung der Stromversorgung bei Stromausfall, Pufferung von Stromspitzen bei der Stromerzeugung) gibt es bei mobilen Anwendungen (PKW, LKW, Busse, aber auch in Gabelstaplern ...) normalerweise keine Fangpunkte, also keine absolut bestimmbaren Batteriekennwerte für die Diagnose (z.B. definitiv voll, definitiv leer, definitiv in kompletter Ruhe, etc....). Der Zustand der Batterie schwankt üblicherweise zwischen 70% und 95% Ladezustand, der Strom ist niemals exakt 0 A und ein Temperaturbereich von - 40 °C bis 90 °C ist möglich, wobei die Temperatur im Betrieb üblicherweise nicht konstant ist.

Zur Diagnose einer Batterie kann diese beispielsweise mittels eines elektrischen Modells beschrieben werden, welches als Eingangsgrößen Batteriestrom, -spannung und -temperatur benötigt. Es gibt auch Lösungen, bei denen nicht der Strom oder die Spannung direkt sondern der Batteriewiderstand bei verschiedenen Frequenzen zur Batteriediagnose benutzt wird. Die Spannung wird dabei normalerweise über einen Analog-Digital-(A/D) Wandler gemessen, welcher einem Spannungsteiler nachgeschaltet ist. Die analogen Größen von Strom und Temperatur werden zunächst jeweils in einen Spannungswert überführt, der dann ebenfalls von einem A/D-Wandler jeweils in einen numerischen Wert umgewandelt wird. Die Erfassung des Stromes erfolgt dabei indirekt über den Spannungsabfall an einem Shunt-Widerstand oder über ein vom Strom induziertes Magnetfeld (z.B. Hall-Effekt). Für die Temperaturmessung bieten sich temperaturabhänge Widerstandsmaterialien wie Kaltleiter, auch als PTC- (positive temperature coefficient) Thermistors bekannt, oder Heißleiter, auch als NTC- (negative temperature coefficient) Thermistors bekannt, an.

Die Spannung wird idealerweise an den Polen der Batterie gemessen. Der komplette Batteriestrom, d.h. die Summe der Ströme aller Verbraucher, wird idealerweise direkt an einem der beiden Pole gemessen, und die Temperatur wird idealerweise im Inneren der Batterie gemessen. Der Batteriestrom wird dabei teilweise aus der Differenz der Ströme von Generator und Bordnetz und/oder aus der Batteriespannung geschätzt.

Alternativ kann jedoch Strom, Spannung und/oder Temperatur auch an anderen Positionen gemessen werden. Der dadurch entstehende Fehler muss dann jedoch durch geeignete Algorithmen numerisch korrigiert/interpoliert werden. Dies erfolgt insbesondere für die Temperatur, welche normalerweise außerhalb der Batterie gemessen wird. Die A/D-Wandlung aller drei Messwerte erfolgt häufig (z.B. bei einem Intelligent Battery Sensor) in der räumlichen Nähe der Batterie. Die A/D-Wandlung kann jedoch auch in jedem beliebigen Steuergerät erfolgen, vorausgesetzt die Messsignale sind ausreichend stark, um bis zum Steuergerät störungsfrei übertragen werden zu können; ggf. kann z.B. eine Verstärkung des Signals in einem Hall-Sensor erfolgen.

Als Kostentreiber hat sich die Messung des Stromes herausgestellt. Daher gab es in der Vergangenheit bereits Ansätze, die Batterie ohne Messung des Batteriestromes zu diagnostizieren. Ziel war es jedoch meist, den Ladezustand oder eine negative Ladebilanz, bei der in Summe die Batterie stärker entladen als geladen wird, abzuschätzen.

Für die Bestimmung des Ladezustands einer Batterie sind aber auch Verfahren denkbar, welche die Messung der Säuredichte (optisch, akustisch, induktiv, ...) zugrunde legen. Die Säuredichte korreliert direkt mit dem Ladezustand der Batterie. Diese Verfahren konnten sich bisher jedoch noch nicht durchsetzen. Eine Ausnahme ist das sogenannte "Magische Auge". Das "Magische Auge" ist als Sichtfenster im Gehäuse der Batterie ausgebildet und zeigt ein Maß für den Säuregehalt bzw. den Ladezustand der Batterie optisch durch Farbänderung an.

Die Startfähigkeit des Fahrzeugs an sich spielte in diesem Zusammenhang allerdings nur eine untergeordnete Rolle, da stets der Fahrer den Verbrennungsmotor abstellte und damit in letzter Konsequenz für seine eigene Mobilität verantwortlich war. Mit Einführung von Start-Stopp-Systemen hat sich der Fokus der Batteriediagnose verschoben. Der Wiederstart des Fahrzeugs an der auf "grün" springenden Ampel ist Kern der derzeitigen Diskussion.

Daher liegt die Aufgabe der vorliegenden Erfindung darin, eine einfache und günstige technische Lösung bereitzustellen, welche die Bestimmung der Startfähigkeit eines Verbrennungsmotors ermöglicht.

Diese Aufgabe wird durch ein Verfahren nach Anspruch 1 und eine Vorrichtung nach Anspruch 7 gelöst.

Vorteilhafte Ausgestaltungen sind Gegenstand der abhängigen Ansprüche.

Das erfindungsgemäße Verfahren zur Bestimmung der Startfähigkeit eines Verbrennungsmotors eines Kraftfahrzeugs, der durch einen von einer Batterie versorgten Elektromotor gestartet werden kann, umfasst folgende Verfahrensschritte:

- Erfassung von ersten Batterie-Parameterwerten bei einem erfolgreichen Startvorgang des Verbrennungsmotors zu einem ersten Zeitpunkt,
- Erfassung von zweiten Batterie-Parameterwerten zu einem dem ersten Zeitpunkt nachfolgenden zweiten Zeitpunkt,
- Bestimmung zum zweiten Zeitpunkt der zur erwartenden Batterie-Spannung für einen zu einem dritten Zeitpunkt folgenden Startvorgang des Verbrennungsmotors basierend auf den erfassten ersten und zweiten Batterie-Parameterwerten,
- Vergleich der zum dritten Zeitpunkt zu erwartende Batterie-Spannung mit einem vorgegebenen Schwellwert, um daraus die Startfähigkeit des Verbrennungsmotors abzuleiten.

Dadurch wird ein Liegenbleiben des Fahrzeugs aufgrund einer nicht mehr ausreichend vorhandenen Batterieleistung vermieden.

In einer vorteilhaften Ausgestaltung der Erfindung liegt die Startfähigkeit vor, wenn die zum dritten Zeitpunkt zu erwartende Batterie-Spannung gleich oder größer dem vorgegebenen Schwellwert ist. Dies hat den Vorteil, dass der Schwellwert der Batterie-Spannung an die anderen elektrischen Geräte, wie das Motor-Steuergerät, angepasst werden kann..

In einer weiteren vorteilhaften Ausgestaltung der Erfindung wird ein zum zweiten Zeitpunkt laufender Verbrennungsmotor nur dann gestoppt, wenn die Startfähigkeit des Verbrennungsmotors zum dritten Zeitpunkt vorliegt. Dadurch wird vermieden, dass das Fahrzeug nach dem Abstellen des Motors nicht mehr gestartet werden kann.

In einer weiteren vorteilhaften Ausgestaltung der Erfindung wird ein zum zweiten Zeitpunkt gestoppter Verbrennungsmotor wieder gestartet, wenn die vorhergesagte Startfähigkeit des Verbrennungsmotors zum dritten Zeitpunkt nicht mehr vorliegt. Das hat den Vorteil, dass der Motor gestartet wird bevor die notwendige Spannung für die Startfähigkeit unterschritten wird.

In einer weiteren vorteilhaften Ausgestaltung der Erfindung umfassen die Parameter die Batterie-Spannung und/oder Batterie-Temperatur. Dies sind Parameter, für welche üblicherweise Sensoren zur Messung bereits vorhanden sind, so dass es keiner zusätzlichen Sensoren bedarf.

In einer weiteren vorteilhaften Ausgestaltung der Erfindung wird als weiterer Parameter eine Spannung zwischen dem Minuspol der Batterie und einer stromdurchflossenen Stelle der Fahrzeugkarosserie gemessen. Diese zusätzliche Spannung dient der Plausibilisierung von Parametern, die der Voraussage der Startfähigkeit zugrunde liegen.

Ein zweiter Aspekt der Erfindung umfasst eine Vorrichtung zur Bestimmung der Startfähigkeit eines Verbrennungsmotors eines Kraftfahrzeugs, der durch einen von einer Batterie versorgten Elektromotor gestartet werden kann, wobei die Vorrichtung folgende Merkmale umfasst:

- wenigstens ein Sensor:

    o zur Erfassung von ersten Batterie-Parameterwerten bei einem erfolgreichen Startvorgang des Verbrennungsmotors zu einem ersten Zeitpunkt, und
    o Erfassung von zweiten Batterie-Parameterwerten zu einem dem ersten Zeitpunkt nachfolgenden zweiten Zeitpunkt,

- Auswerteeinheit:

    o zur Bestimmung zum zweiten Zeitpunkt der zur erwartenden Batterie-Spannung für einen zu einem dritten Zeitpunkt folgenden Startvorgang des Verbrennungsmotors basierend auf den erfassten ersten und zweiten Batterie-Parameterwerten,
    ∘ Zum Vergleich der zum dritten Zeitpunkt zu erwartenden Batterie-Spannung mit einem vorgegebenen Schwellwert, um daraus die Startfähigkeit des Verbrennungsmotors abzuleiten.

Das hat den Vorteil, dass durch die Bestimmbarkeit der Startfähigkeit des Verbrennungsmotors ein Liegenbleiben des Fahrzeugs aufgrund einer nicht mehr ausreichend vorhandenen Batterieleistung, vermieden werden kann.

In einer vorteilhaften Ausgestaltung der Erfindung ist die Auswerteeinheit dafür ausgelegt, den wenigstens einen Sensor zur Erfassung der ersten und zweiten Batterie-Parameterwerte zu dem ersten und zweiten Zeitpunkt anzusteuern. Dadurch werden die ersten- und zweiten Batterie-Parameterwerte aktuell erfasst, und ebenso wird die Startfähigkeit aus aktuellen Werten ermittelt, so dass eine Vorhersage der Startfähigkeit entsprechend genau ist.

Im Folgenden soll die Erfindung anhand der Figuren 1 bis 3 beispielhaft erläutert werden. Es zeigen schematisch:

Figur 1      erfindungsgemäße Vorrichtung;

Figur 2      elektrisches Modell für Batterie und Anlasser; und

Figur 3      Diagramm Batteriespannung vs Zeit.

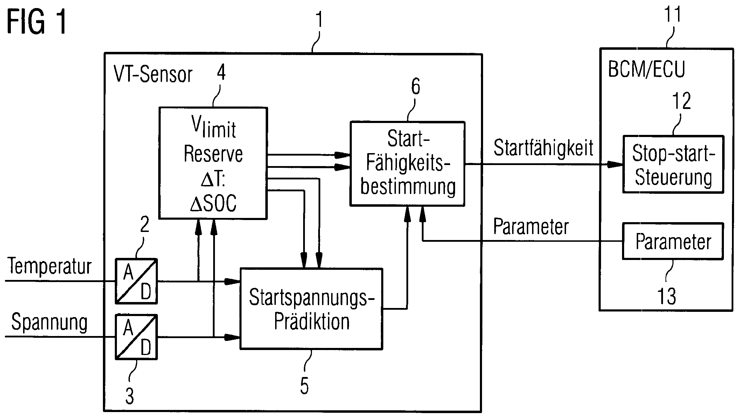

Figur 1 zeigt eine Sensor- und Auswerteeinheit 1 und eine Motorsteuerungseinheit 11. Die Sensor- und Auswerteeinheit 1 umfasst einen ersten A/D-Wandler 2, welcher als Eingang ein analoges Temperatursignal hat, und einen zweiten A/D-Wandler 3, welcher als Eingang eine analoge Spannung hat. Im dem ersten- und zweiten A/D-Wandler 2, 3 werden die analogen Eingangsgrößen in digitale Werte umwandelt.

Die Sensor- und Auswerteeinheit 1 umfasst weiterhin die Blöcke 4, 5 und 6.

In Block 4 "$V_{limit}$ Reserve $\Delta T$ $\Delta SOC$" wird mit entsprechenden Algorithmus aus den digitalisierten Temperatur- und Spannungswerten die Änderung der Temperatur $\Delta T$ und des Ladezustands $\Delta SOC$ der Batterie seit dem letzten Start berechnet.

In Block 5 "Startspannungsprädiktion" wird aus der Batteriespannung beim zuletzt erfolgten Motorstart des Kraftfahrzeugs und mithilfe der Werte $\Delta T$, $\Delta SOC$ die prädizierte Batteriespannung für den nächsten Motorstart berechnet.

In Block 6 "Startfähigkeitsbestimmung" wird die prädizierte Startspannung mit der mindestens zum Motorstart erforderlichen Batteriespannung verglichen. Die mindestens erforderliche Batteriespannung kann als Parameter von der Motorsteuerungseinheit 11 BCM/ECU vorgegebenen sein, aus der Batterietemperatur berechnet werden oder auch ein fest vorgegebener Wert sein. Das Ergebnis des Vergleichs wird als Parameter "Startfähigkeit" der Stop-Start-Steuerung 12 übergeben, die wiederum die Startfähigkeit in die Entscheidung einbezieht, ob der Motor abgestellt werden kann oder nicht, den Motor automatisch aktiviert oder den Fahrer auffordert den Motor zu starten.

Figur 1 zeigt ferner eine Motorsteuerungseinheit 11, welche mit der Sensor- und Auswerteeinheit 1 austauschen kann. Die Motorsteuerungseinheit 11 umfasst eine Stop-Start-Steuerung 12 und eine Speichereinheit in welcher Parameter 13 der Start-Stop-Steuerung 12 hinterlegt sind.

Der Sensor zur Messung von Spannung und Temperatur kann vorteilhafterweise folgende Bestandteile umfassen:

- Gehäuse mit Stecker und/oder Kabelschwanz und/oder Metalllasche,
- ein oder zwei Analog-Digital-Wandler zur Übersetzung von Spannungen in numerische Werte,
- Auswerteeinheit (Mikrocontroller) zur Berechnung der Startfähigkeit sowie weiterer Größen,
- Kommunikationsausgang (evtl. auch Eingang) zur Übermittlung der Startfähigkeit an übergeordnetes Steuergerät (z.B. LIN, CAN oder PWM),
- Temperatursensor, welcher ein Spannungssignal generiert (z.B. NTC-Widerstand) innerhalb oder außerhalb des Gehäuses mit guter thermischen Anbindung zur Batterie,
- je eine elektrische Verbindung vom Analog-Eingang des A/D-Wandlers zum Pluspol und zum Minuspol der Batterie, alternativ auch zu zwei Punkten bzw. Anschlüssen im Bordnetz, zwischen welchen annähernd die Batteriespannung anliegt.

Der Sensor kann in der Motorsteuerung, in einem Body-Controller, in der Batterie oder auch als eigenständige elektronische Einheit angeordnet sein.

Zudem kann der Sensor in Form einer mit elektronischen Bauteilen bestückten Leiterplatte ausgebildet sein, die als Ganzes wiederum in ein Steuergerät des Fahrzeugs eingebaut wird oder auf eine Steuergeräte-Leiterplatte bestückt wird.

Konkret könnte das Gehäuse einen Stecker mit zwei Pins für einen local interconnect network (LIN), also einen seriellen Bus-Anschluss und einen Anschluss für den Pluspol der Batterie (B+) aufweisen. Über B+ wird sowohl die Messspannung zugeführt als auch die Stromversorgung des Sensors sichergestellt. Die LIN-Leitung ist beispielsweise mit einem Bodycontroller oder mit der Motorsteuerung verbunden und erhält von dieser auch Informationen. Eine aus dem Gehäuse herausgeführte Metalllasche verbindet den Sensor mechanisch mit dem Minuspol der Batterie und stellt darüber hinaus eine elektrische Verbindung, sowie die thermische Ankopplung zum Batterieinneren, sicher. Alternativ kann die Spannung des Minuspols auch über den Stecker zugeführt werden.

Die erfindungsgemäße Vorrichtung kann ferner weitere Komponenten umfassen, wie beispielsweise ein Bauteil zur Stromversorgung, das gleichzeitig eine hochgenaue Referenzspannung (z.B. 3V) zur Verfügung stellt. Weiterhin kann die Vorrichtung einen Mikrocontroller ($\mu$C) (z.B. NEC, 24kByte ROM) umfassen, der bereits einen A/D-Wandler (10 bis 16 bit) beinhaltet. Auch ein Spannungsteiler, der die Batteriespannung auf 5 bis 50% der ursprünglichen Spannung reduziert kann vorgesehen sein. Ein zusätzlicher Spannungsteiler der Referenzspannung mit einem NTC (guter elektrischen Kontakt zur Lasche) würde eine zweite von der Temperatur abhängige Spannung liefern. Beide Spannungen würden vom A/D-Wandler in numerische Werte übersetzt und vom Prozessor weiterverarbeitet werden. Die vom Prozessor berechnete Startfähigkeit kann über einen LIN-Anschluss an das übergeordnete Steuergerät übergeben werden. Alle Bauteile können über eine Leiterplatte miteinander verbunden werden. Eine mangelnde Startfähigkeit würde dann in den übergeordneten Steuergeräten zu Reaktionen führen, welche die Mobilität sicherstellen würden.

Konkret kann das tatsächliche Startverhalten durch Minimalspannung und/oder Dauer des Startvorgangs und/oder Änderung der Spannung (dU/dt) während des Startvorgangs und/oder Integration des Spannungseinbruchs über die Zeit beschrieben werden. Die Änderung der Startfähigkeit (hier beispielhaft minimale Startspannung) kann konkret aus einem elektrischen Modell der Batterie ( $V_{Batterie} = f\left(SOC, T_{Batterie}, V_{Polarisation}, R_{Anlasser}, Q_{Batterie}^{max}\right)$ ), wie nachfolgend beschrieben, berechnet werden.

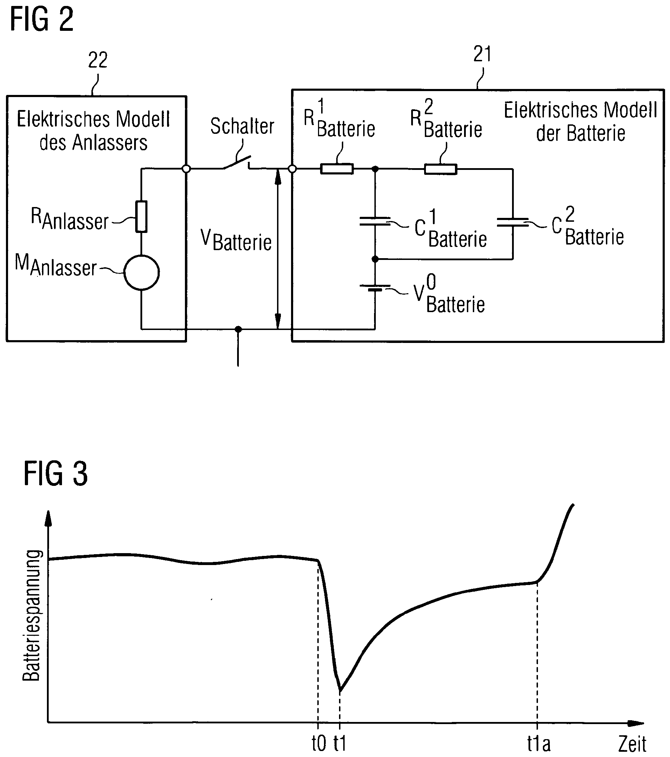

Figur 2 zeigt ein elektrisches Modell der Batterie 21 und des Anlassers 22, welche durch einen Schalter elektrisch verbunden werden können.

Hierbei ist $R_{Anlasser}$ der elektrische Widerstand des Anlassers, $M_{Anlasser}$ der elektrische Motor, der bei Drehzahl > 0 eine Gegenspannung induziert, $R_{Batterie}^1$ und $R_{Batterie}^2$ zwei unterschiedliche elektrische Widerstände innerhalb der Batterie, $C_{Batterie}^1$ und $C_{Batterie}^2$ zwei unterschiedliche elektrische Kondensatoren innerhalb der Batterie und $V_{Batterie}^0$ ein Spannungsoffset innerhalb der Batterie. Die Summe der beiden Ladungsinhalte der Kondensatoren 1 und 2 ( $Q_{Batterie}^1$ und $Q_{Batterie}^2$ dividiert durch die maximale Ladungsmenge $Q_{Batterie}^{max}$ der Batterie wird üblicherweise als Ladungszustand, auch unter state-of-charge (SOC) bekannt,

$$SOC = \frac{Q_{Batterie}^1 + Q_{Batterie}^2}{Q_{Batterie}^{MAX}}$$

bezeichnet. Spannungsunterschiede der beiden Kondensatoren

$$V_{Batterie}^1 - V_{Batterie}^2 = \frac{Q_{Batterie}^1}{C_{Batterie}^1} - \frac{Q_{Batterie}^2}{C_{Batterie}^2}$$

können als Polarisationsspannung

$$V_{Polarisation} = V_{Batterie}^1 - V_{Batterie}^2$$

der Batterie bezeichnet werden. Sowohl die beiden Kapazitäten der Batterie als auch beide Widerstände hängen zusätzlich nichtlinear von der Batterietemperatur $T_{Batterie}$ und den Batteriespannungen $V_{Batterie}^1$ und $V_{Batterie}^2$ ab.

Zum Zeitpunkt t0 werden die Größen $R_{Anlasser}$, $R_{Batterie}^1$ , $R_{Batterie}^2$ , $C_{Batterie}^1$ , $C_{Batterie}^2$ , $V_{Batterie}^0$ , $Q_{Batterie}^1$ , $Q_{Batterie}^2$ , $Q_{Batterie}^{max}$ und $T_{Batterie}$ als bekannt angenommen.

Wird nun der Schalter zwischen Batterie und Anlasser geschlossen, dann stellt sich zum Zeitpunkt t1 im elektrischen Modell folgende prädizierte Batteriespannung $V_{Batterie} = V_{prädiziert}$ ein:

$$V_{prädiziert}(t_1) = \frac{V_{Batterie}^1 + V_{Batterie}^0}{\left(1 - \dfrac{R_{Batterie}^1}{R_{Anlasser}}\right)} \; .$$

Figur 3 zeigt ein Diagramm der Batteriespannung über die Zeit. Die Zeitpunkte t0 und t1 sind nahezu identisch. Die Dauer des Spannungsabfalls wird im Wesentlichen durch die Induktivität der Zuleitungen beeinflusst. Zwischen t1 und t1a sinken die Spannungen $V_{Batterie}^1$ und $V_{Batterie}^2$ infolge der Entladung während gleichzeitig die induzierte Gegenspannung des Anlasser-Motors zunimmt. Ab dem Zeitpunkt t1a beginnt der Generator mit dem Laden der Batterie. Gleichzeitig wird im Zeitpunkt t1 (Spannungsminimum) die Spannung $V_{Messung}(t_1)$ vom A/D-Wandler gemessen.

Zwischen dem Zeitpunkt t1 und einem späteren Zeitpunkt t2 liegt nun ein Spannungsprofil $V_{Batterie}(t)$ an der Batterie an. Hierdurch ergeben sich die zwei folgenden Differentialgleichungen für die beiden Spannungen der Batterie:

$$\frac{dV^1_{Batterie}(t)}{dt} = \frac{V_{Batterie}(t) - V^1_{Batterie}(t) - V^0_{Batterie}}{R^1_{Batterie}(T_{Batterie}) \cdot C^1_{Batterie}(T_{Batterie})} - \frac{V^1_{Batterie}(t) - V^2_{Batterie}(t)}{R^2_{Batterie}(T_{Batterie}) \cdot C^1_{Batterie}(T_{Batterie})}$$

$$\frac{dV^2_{Batterie}(t)}{dt} = \frac{V^1_{Batterie}(t) - V^2_{Batterie}(t)}{R^2_{Batterie}(T_{Batterie}) \cdot C^2_{Batterie}(T_{Batterie})}$$

Diese Differentialgleichungen können unter Kenntnis der Temperatur-Abhängigkeiten gelöst werden. Somit können die Spannungen $V^1_{Batterie}(t_2)$ und $V^2_{Batterie}(t_2)$ zum Zeitpunkt t2 berechnet werden. Die prädizierte Spannung zum Zeitpunkt t2 beträgt:

$$V_{prädiziert}(t_2) = \frac{V^1_{Batterie}(t_2) + V^0_{Batterie}(t_2)}{\left(1 - \frac{R^1_{Batterie}(t_2)}{R_{Anlasser}(t_2)}\right)} + V_{Messung}(t_1) - V_{prädiziert}(t_1)$$

In einer weiteren, vereinfachten Berechnungsmethode für die prädizierte Spannung gemäß dieser Formel wird nur ihre Abhängigkeit von der zeitlichen Änderung bestimmter Batterieparameter wie SOC, T und $V_{Polarisation}$ berücksichtigt. Ist zum Zeitpunkt t1 die Abhängigkeit der modellierten Batteriespannung von SOC ( $\frac{\partial V_{Batterie}}{\partial SOC}$ ) , von Temperatur ( $\frac{\partial V_{Batterie}}{\partial T_{Batterie}}$ ) und von der Polarisationsspannung ( $\frac{\partial V_{Batterie}}{\partial V_{Polarisation}}$ ) bekannt, so kann die prädizierte Spannung mithilfe der vorgenannten Ausdrücke $T_{Batterie} = V_{prädiziert}$ und $V_{prädiziert}(t_1) = \frac{V^1_{Batterie} + V^0_{Batterie}}{\left(1 - \frac{R^1_{Batterie}}{R_{Anlasser}}\right)}$ wie folgt umgeschrieben werden:

$$V_{prädiziert}(t_2) = V_{Messung}(t_1) + \frac{\partial V_{Batterie}}{\partial SOC}(SOC(t_2) - SOC(t_1))$$
$$+ \frac{\partial V_{Batterie}}{\partial T_{Batterie}}(T_{Batterie}(t_2) - T_{Batterie}(t_1))$$
$$+ \frac{\partial V_{Batterie}}{\partial V_{Polarisation}}(V_{polarisation}(t_2) - V_{polarisation}(t_1))$$

$V_{prädiziert}(t_2)$ ist die zu erwartende Spannung, welche sich aus dem Modell ergibt. $V_{Messung}$ ist die aktuelle gemessene Spannung. $V_{polaristion}$ ist die sogenannte Polarisationsspannung, die im Folgenden kurz erklärt wird:

Die Batteriespannung, welche zur Nutzung bereit steht, setzt sich aus der Ruhespannung und der Polarisationsspannung zusammen. Die Ruhespannung liegt an der Batterie an wenn für wenigstens einige Stunden kein Verbraucher angeschlossen ist. Im Betrieb der Batterie ist üblicherweise ein Verbraucher angeschlossen, währenddessen sich innerhalb der Batterie Ungleichgewichte, beispielsweise hinsichtlich der räumlichen Ionenverteilung, einstellen können. Diese Ungleichgewichte erzeugen eine zusätzliche Spannung die auch als Polarisationsspannung bezeichnet wird.

Das Modell soll für Startvorgänge, welche etwa 5 bis 250 Sekunden nach dem Abschalten des Verbrennungsmotors stattfinden, und für minimale Startspannungen um etwa 6 bis 8V bei 12V-Systemen und 12 bis 16V bei 24V-Systemen, optimiert sein.

Die Größe und Typ der Batterie werden nach einem beobachteten Startverhalten als unverändert angenommen.

Die Änderung der Batterietemperatur wird über ein numerisches Modell berechnet, welches sowohl die Messtemperatur als auch einen geschätzten Batteriestrom berücksichtigt.

Die Änderung des Ladezustands (SOC) wird über ein weiteres numerisches Modell berechnet, welches die Batteriegröße und einen geschätzten Batteriestrom berücksichtigt. Beispielsweise kann die SOC-Änderung über das Integral des geschätzten relativen Batteriestromes bestimmt werden:

$$\Delta SOC = \int_{\substack{\text{Zeitpunkt des} \\ \text{letzten Startvorgangs}}}^{\text{aktuelle Zeit}} I_{BAT\_relativ}^{geschätzt} \cdot dt$$

Die Änderung der Polarisationsspannung wird ebenfalls über ein Modell berechnet, welches die Batteriespannung- und temperatur berücksichtigt.

Der Batteriestrom wird aus Ladezustand (SOC), Batteriespannung und -temperatur geschätzt. Beispielsweise kann der relative Batteriestrom aus der Spannungsmessung wie folgt geschätzt werden:

$$I_{BAT\_relativ}^{geschätzt} = I_{Ladung} + I_{Entladung}$$

$$I_{Entladung} = \begin{cases} \dfrac{V_{mess} - V_{0}^{Entladung}}{Q_{max} \cdot R_{eff}} & V_{mess} < V_{0}^{Entladung} \\ 0 & V_{mess} \geq V_{0}^{Entladung} \end{cases}$$

$$I_{Ladung} = \begin{cases} \dfrac{V_{mess} - V_{0}^{Ladung}}{Q_{max} \cdot R_{eff}} & V_{mess} \geq V_{0}^{Ladung} \\ 0 & V_{mess} < V_{0}^{Ladung} \end{cases}$$

mit

$$V_{0}^{Entladung} = 12.7V$$

$$V_{0}^{Ladung} = 13.5V - 12\frac{mV}{K}\left(T - 25°C\right)$$

Dabei ist $Q_{max} * R_{eff}$ ein systemspezifischer, experimentell bestimmbarer Parameter. Der relative Batteriestrom bezieht sich immer auf die maximale Batteriekapazität $Q_{max}$. $I_{Entladung}$ und $I_{Ladung}$ sind die jeweiligen Ströme bei Ladung und Entladung zur gemessenen Spannungen $V_{mess}$ zu den jeweiligen Zeitpunkten. $V_{OLadung}$ und $V_{0Entladung}$ sind Kalibrierparameter, die entsprechend vorgegeben sind.

Die Startfähigkeit wird konkret als gegeben betrachtet, falls

- die Minimalspannung oberhalb einer Grenzspannung liegt,
- die Startdauer unterhalb einer Zeitgrenze liegt,
- das Integral des Spannungseinbruchs über die Zeit unterhalb einer Grenze liegt,
- die Spannungsdynamik unterhalb einer Grenze liegt.

Die Grenzwerte können darüber hinaus von der Auslegung des Systems aus Anlasser und Batterie, von Temperatur der Batterie und/oder des Motors sowie vom Ladezustand abhängen. Als zusätzlicher Schutz gegen ein Nichtstarten, d.h. Liegenbleiben, kann der Generatorstrom für eine bestimmte Dauer (z.B. 1 sec) vor Abschaltung des Verbrennungsmotors auf 0 A reduziert werden. Der Verbrauchstrom wird dann für diese Dauer komplett aus der Batterie versorgt.

Durch die Analyse des hierdurch verursachten Spannungseinbruchs können die seit dem letzten Start zusätzlich aufgetretenen Fehler innerhalb der Batterie erkannt werden bevor der Motor abgeschaltet wird.

Darüber hinaus kann der Sensor zur Messung von Spannung und Temperatur einen Leistungswiderstand aufweisen, welcher regelmäßig parallel zur Batterie geschaltet wird und somit der Batterie einen zusätzlichen Strom aufprägt (z.B. 20mA). Die Dauer kann beispielsweise in einem Bereich von 1ms bis 1 Stunde liegen. Durch Auswertung der Spannungsantwort kann auf den Zustand der Batterie geschlossen werden.

Das Ausführungsbeispiel umfasst einen eigenständigen Sensor zur Messung von Spannung und Temperatur der Batterie sowie einen Algorithmus, welcher einem übergeordneten Steuergerät mindestens die Startfähigkeit für Start-Stop-Systeme in Kraftfahrzeugen mit Verbrennungsmotor übermittelt. Der hier beschriebene Sensor kann auch in ein anderes Steuergerät hinein, in Bauteile der Batterie (z.B. Deckel) oder Anbauteile an der Batterie (Batteriekabel, Polklemme, Sicherungskasten, Abdeckhaube des Pluspols) integriert werden.

Die Erfindung beruht auf der Idee, dass selbst ohne genaue Kenntnis der in der Batterie enthaltenen absoluten oder relativen Ladungs- oder Energiemenge das zukünftige Verhalten der Batterie beim nächsten Motorstart vorhergesagt wird. Dazu wird das Verhalten der Batterie bei mindestens einem der vorhergehenden Motorstarts ausgewertet und es wird die zu erwartende Änderung dieses Verhaltens allein aufgrund der beobachteten Batteriespannung- und temperatur über eine begrenzte Zeit vorausberechnet.

Im Ergebnis ergibt sich eine deutliche Kostenersparnis, weil auf die Strommessung verzichtet werden kann. Weiterhin verzichtet die Erfindung aus Kostengründen bewusst auf eine Bestimmung der Säuredichte.

Die Startfähigkeit kann auch unabhängig vom tatsächlichen, vorhergehenden Startverhalten prädiziert werden:

$$V_{prädiziert}(t_2) = \left(OCV + V_{polarisaton}\right) \cdot \frac{R_{starter}}{R_{battery} + R_{starter}}$$

Hierfür sind jedoch wesentlich mehr Annahmen über Parameter der Batterie und des Starters erforderlich. OCV (open circuit voltage ) ist die Ruhespannung, also die Spannung, welche sich nach wenigstens einigen Stunden ohne angeschlossenen Verbraucher einstellt. $V_{polarisation}$ wurde bereits oben beschrieben, und kann entsprechend bestimmt werden. $R_{starter}$ ist der elektrische Widerstand des Starters bzw. Anlassers und $R_{battery}$ ist der elektrische Widerstand der Batterie. Die Widerstände können berechnet oder gemessen werden.

Weitere Ausführungsbeispiele

- Die Batteriediagnose kann über die Bestimmung der Säuredichte erfolgen.
- Die Spannung der Batterie kann über zwei Leitungen einem existierenden Steuergerät zugeführt werden und innerhalb dieses Gerätes in numerische Werte übersetzt werden.
- Die Spannung kann etwas abseits der Batteriepole (z.B. am Ende des Batteriekabels) abgegriffen werden.
- Die Temperatur kann durch einen Temperatursensor in oder an der Batterie in eine elektrische Spannung gewandelt, einem existierenden Steuergerät zugeführt und innerhalb dieses Gerätes in numerische Werte übersetzt werden.
- Die Batterietemperatur kann aus der Umgebungstemperatur und einem Modell für Aufwärmung und Abkühlung geschätzt werden.
- Der Sensor zur Messung von Spannung und Temperatur kann in die Batterie integriert werden.
- Die Kommunikation kann drahtlos (z.B. Funk) erfolgen.
- Die elektrischen Verbindungen können als Kabelschwanz, Steckkontakt oder aus dem Sensor herausragende Stege erfolgen.
- Der Sensor zur Messung von Spannung und Temperatur kann mechanisch mit einer Polklemme (plus oder minus), mit einem Batteriekabel, mit Teilen der Batterie oder mit einem der Batterie nahen Bauteil verbunden werden.
- Statt eines Gehäuses ist auch eine dichte Umspritzung oder Lackierung möglich.
- Statt einer Leiterplatte kann auch ein Substrat benutzt werden. Die elektrische Verbindung erfolgt dann durch Kleben (Bonding).
- Alle oder ein Teil der relevanten Funktionen (Spannungsversorgung, Referenz, AD-Wandler, μC, Spannungsteiler, NTC, ...) können in einen Chip integriert werden.
- Der Batteriestrom kann aus der Differenz von Generatorstrom und Verbraucherstrom geschätzt werden, sofern beide Größen verfügbar sind. Die Belastung der Batterie durch den aktuellen Verbraucherstrom kann durch kurzzeitiges Abschalten des Generators ermittelt werden, wobei die Batteriespannung vor, während und nach der Deaktivierung des Generators gemessen und/oder ausgewertet wird.

- Die Startfähigkeit kann in verschiedenen Formen an das übergeordnete Steuergerät übermittelt werden (möglich/nicht möglich, 0 bis 100%, ±50%, usw. ...).
- Der Algorithmus kann Informationen vom übergeordneten Steuergerät erhalten (erlaubte minimale Startspannung, Zustand der Verbrennungsmotors, Zustand der Klemme) oder auch darauf verzichten.
- Die Startfähigkeit kann auch optisch und/oder visuell (in einem Display) dargestellt werden.
- Zur Berechnung der Startfähigkeit können neben der Minimalspannung zusätzlich z.B. die Dauer, die Dynamik und/oder die benötigte Energiemenge des Startvorgangs berücksichtigt werden.
- Die Grenzen der Startfähigkeit können fix oder veränderlich sein.
- Neben der Startfähigkeit können noch weitere Informationen (Batteriealterungsgrad, optimale Ladestrategie, ....) dem übergeordneten Steuergerät übermittelt werden.
- Der Sensor zur Messung von Spannung und Temperatur kann mehr als die genannten Bauteile aufweisen. Hierzu gehören insbesondere RC-Filter, Transistoren, CAN-Treiber und Speicher. Darüber hinaus können weitere Funktionalitäten integriert werden.
- Insbesondere kann der Sensor zur Messung von Spannung und Temperatur Bauteile (Transistor, Widerstand, ....) enthalten, welche der Batterie in (un)-regelmäßigen Abständen einen zusätzlichen Strom aufprägen.
- Die erfindungsgemäße Vorrichtung kann zudem einen eigenständigen Sensor zur Messung von Spannung und Temperatur an der Batterie aufweisen.

Wie bereits ausgeführt, hat die vorliegende Erfindung zum Gegenstand ein Verfahren bzw. eine Vorrichtung zur Bestimmung der Startfähigkeit eines Verbrennungsmotors mittels einer Starterbatterie, wobei im Gegensatz zu herkömmlichen Verfahren aus Kostengründen auf eine Messung des Batteriestroms verzichtet wird. Stattdessen wird der Batteriestrom bzw. die Änderung der in der Batterie gespeicherten Ladung mittels eines Modells aus gemessenen Größen (Spannung und Temperatur der Batterie) und als bekannt angenommenen Batterieparametern geschätzt. Abweichungen vom erwarteten Verhalten der Batterie beeinträchtigen die Startfähigkeitsprädiktion.

Daher ist eine weitere Ausgestaltung der Erfindung vorteilhaft, wobei über eine zusätzliche Vorrichtung eine Plausibilisierung des vom Modell errechneten Batteriestroms ermöglicht wird. Hierbei wird über einen weiteren A/D-Wandler eine weitere Spannung gemessen, und zwar die Spannung zwischen einer stromdurchflossenen Stelle an der Fahrzeugkarosserie und dem Minuspol der Batterie. Üblicherweise sind sowohl die elektrischen Verbraucher, als auch der Generator im Fahrzeug, mit ihrem Minuspol elektrisch mit der Karosserie verbunden, so dass die Karosserie ein Teil des Stromkreises ist, der die Verbraucher und den Generator mit der Fahrzeugbatterie verbindet. Zwischen jedem beliebigen Punkt der Karosserie und dem Minuspol der Batterie ist zwangsläufig ein elektrischer Widerstand vorhanden. Wird nun die Karosserie mit dem Strom der elektrischen Verbraucher oder des Generators im Fahrzeug durchflossen, bewirkt dieser Widerstand einen Spannungsabfall zwischen dem Kontaktpunkt an der Karosserie und dem Minuspol der Batterie. Insbesondere kann durch das Vorzeichen dieses Spannungsabfalls erkannt werden, ob die Batterie durch den Generator geladen wird, oder eine Entladung der Batterie durch Verbraucher im Fahrzeug stattfindet.

Die vorliegende Erfindung beschreibt eine alternative Lösung zur Diagnose der Startfähigkeit einer Batterie für Start-Stop-Systeme, insbesondere von Batterien auf Basis von Blei und Schwefelsäure. Start-Stop-Systeme zeichnen sich dadurch aus, dass der Abstand zwischen zwei aufeinanderfolgenden Startvorgängen kurz ist (Stop-and-Go-Verkehr), und dass die Spannung während des Startvorgangs nicht unter eine Mindestspannung, z.B. 8V, einbrechen soll, da sonst eine Unterbrechung des Betriebs von z. B. Radio und/oder Navigationsgeräten eintreten könnte.

Eine Vorhersage der Startfähigkeit des Verbrennungsmotors auf Basis der vorliegenden Diagnose der Fahrzeugbatterie hat den Vorteil, dass im Vergleich zu herkömmlichen Systemen eine Strommessung nicht erforderlich ist und entsprechend die Kosten für eine Strommessung eingespart werden können.

Die Erfindung wird vorteilhaft bei PKWs und LKWs eingesetzt.

**Patentansprüche**

1. Verfahren zur Bestimmung der Startfähigkeit eines Verbrennungsmotors eines Kraftfahrzeugs, der durch einen von einer Batterie versorgten Elektromotor gestartet werden kann, mit den Verfahrensschritten:

   - Erfassung von ersten Batterie-Parameterwerten bei einem erfolgreichen Startvorgang des Verbrennungsmotors zu einem ersten Zeitpunkt,
   - Erfassung von zweiten Batterie-Parameterwerten zu einem dem ersten Zeitpunkt nachfolgenden zweiten Zeitpunkt,
   - Bestimmung zum zweiten Zeitpunkt der zur erwartenden Batterie-Spannung für einen zu einem dritten Zeitpunkt folgenden Startvorgang des Verbrennungsmotors basierend auf den erfassten ersten und zweiten Batterie-Parameterwerten,

- Vergleich der zum dritten Zeitpunkt zu erwartende Batterie-Spannung mit einem vorgegebenen Schwellwert, um daraus die Startfähigkeit des Verbrennungsmotors abzuleiten.

2. Verfahren nach Anspruch 1, bei dem die Startfähigkeit vorliegt, wenn die zum dritten Zeitpunkt zu erwartende Batterie-Spannung gleich oder größer dem vorgegebenen Schwellwert ist.

3. Verfahren nach Anspruch 1 oder 2, bei dem ein zum zweiten Zeitpunkt laufender Verbrennungsmotor nur dann gestoppt wird, wenn die Startfähigkeit des Verbrennungsmotors zum dritten Zeitpunkt vorliegt.

4. Verfahren nach Anspruch 1 oder 2, bei dem ein zum zweiten Zeitpunkt gestoppter Verbrennungsmotor wieder gestartet wird, wenn die Startfähigkeit des Verbrennungsmotors zum dritten Zeitpunkt nicht mehr vorliegt.

5. Verfahren nach einem der Ansprüche 1 bis 4, wobei die Parameter die Batterie-Spannung und/oder Batterie-Temperatur umfassen.

6. Verfahren nach einem der vorherigen Ansprüche, bei dem als weiterer Parameter eine Spannung zwischen dem Minuspol der Batterie und einer stromdurchflossenen Stelle der Fahrzeugkarosserie gemessen wird.

7. Vorrichtung zur Bestimmung der Startfähigkeit eines Verbrennungsmotors eines Kraftfahrzeugs, der durch einen von einer Batterie versorgten Elektromotor gestartet werden kann, wobei die Vorrichtung folgende Merkmale umfasst:

   - wenigstens ein Sensor:

       o zur Erfassung von ersten Batterie-Parameterwerten bei einem erfolgreichen Startvorgang des Verbrennungsmotors zu einem ersten Zeitpunkt, und
       o Erfassung von zweiten Batterie-Parameterwerten zu einem dem ersten Zeitpunkt nachfolgenden zweiten Zeitpunkt,

   - Auswerteeinheit:

       o zur Bestimmung zum zweiten Zeitpunkt der zur erwartenden Batterie-Spannung für einen zu einem dritten Zeitpunkt folgenden Startvorgang des Verbrennungsmotors basierend auf den erfassten ersten und zweiten Batterie-Parameterwerten,
       ∘ Zum Vergleich der zum dritten Zeitpunkt zu erwartende Batterie-Spannung mit einem vorgegebenen Schwellwert, um daraus die Startfähigkeit des Verbrennungsmotors abzuleiten.

8. Vorrichtung nach Anspruch 7, bei der die Auswerteeinheit dafür ausgelegt ist, den wenigstens einen Sensor zur Erfassung der ersten und zweiten Batterie-Parameterwerte zu dem ersten und zweiten Zeitpunkt anzusteuern.


**Claims**

1. Method for determining the starting capability of an internal combustion engine of a motor vehicle, which internal combustion engine can be started by an electric motor which is supplied by a battery, having the method steps:

   - detecting first battery parameter values during a successful starting process of the internal combustion engine at a first time,
   - detecting second battery parameter values at a second time following the first time,
   - determining, at the second time, the expected battery voltage for a starting process of the internal combustion engine which follows at a third time and is based on the detected first and second battery parameter values,
   - comparing the battery voltage expected at the third time with a predefined threshold value in order to derive the starting capability of the internal combustion engine therefrom.

2. Method according to Claim 1, in which the starting capability is present if the battery voltage expected at the third time is equal to or greater than the predefined threshold value.

3. Method according to Claim 1 or 2, in which an internal combustion engine which is running at the second time is stopped only if the starting capability of the internal combustion engine is present at the third time.

4. Method according to Claim 1 or 2, in which an internal combustion engine which is stopped at the second time is restarted if the starting capability of the internal combustion engine is no longer present at the third time.

5. Method according to one of Claims 1 to 4, wherein the parameters comprise the battery voltage and/or battery temperature.

6. Method according to one of the preceding claims, in which, as a further parameter, a voltage between the negative pole of the battery and a point on the vehicle bodywork through which current flows is measured.

7. Device for determining the starting capability of an internal combustion engine of a motor vehicle which can be started by an electric motor supplied by a battery, wherein the device comprises the following features:

    - at least one sensor:

        ° for detecting first battery parameter values during a successful starting process of the internal combustion engine at a first time, and
        ° detecting second battery parameter values at a second time following the first time,

    - evaluation unit:

        ◦ for determining, at the second time, the expected battery voltage for a starting process of the internal combustion engine which follows at a third time and is based on the detected first and second battery parameter values, and
        ° for comparing the battery voltage expected at the third time with a predefined threshold value in order to derive the starting capability of the internal combustion engine therefrom.

8. Device according to Claim 7, in which the evaluation unit is configured to actuate the at least one sensor in order to detect the first and second battery parameter values at the first and second times.

**Revendications**

1. Procédé de détermination de la possibilité de démarrer le moteur à combustion interne d'un véhicule automobile qui peut être démarré par un moteur électrique alimenté par une batterie, le procédé présentant les étapes suivantes :

    saisie de premières valeurs de paramètres de batterie lors d'une opération réussie de démarrage du moteur à combustion interne à un premier moment,
    saisie de deuxièmes valeurs de paramètres de batterie à un deuxième instant suivant le premier instant,
    sur la base des premières et des deuxièmes valeurs de paramètres de batterie qui ont été saisies, détermination au deuxième instant, qui suit le troisième instant, de la tension attendue de la batterie en vue d'une opération de démarrage du moteur à combustion interne et
    comparaison de la tension de batterie attendue au troisième instant à une valeur de seuil prédéterminée pour en déduire la possibilité de démarrer le moteur à combustion interne.

2. Procédé selon la revendication 1, dans lequel le démarrage est possible si la tension de batterie attendue au troisième instant est égale ou supérieure à la valeur de seuil prédéterminée.

3. Procédé selon les revendications 1 ou 2, dans lequel un moteur à combustion interne qui tourne au deuxième instant n'est arrêté que si le moteur à combustion interne peut être démarré au troisième instant.

4. Procédé selon les revendications 1 ou 2, dans lequel si le moteur à combustion interne ne peut plus être démarré au troisième instant, le moteur à combustion interne arrêté au deuxième instant est redémarré.

5. Procédé selon l'une des revendications 1 à 4, dans lequel les paramètres comprennent la tension de batterie et/ou la température de la batterie.

**6.** Procédé selon l'une des revendications précédentes, dans lequel la tension entre les pôles moins de la batterie et un emplacement de la carrosserie du véhicule traversé par le courant est mesurée comme autre paramètre.

**7.** Ensemble de détermination de la possibilité de démarrer le moteur à combustion interne d'un véhicule automobile qui peut être démarré par un moteur électrique alimenté par une batterie, l'ensemble présentant les caractéristiques suivantes :

au moins un capteur qui détecte des premières valeurs de paramètres de batterie lors d'une opération de démarrage réussie du moteur à combustion interne à un premier instant,
qui détecte des deuxièmes valeurs de paramètres de batterie à un deuxième instant qui suit le premier instant,
une unité d'évaluation qui détermine au deuxième instant et sur la base des premières et des deuxièmes valeurs de paramètres de batterie qui ont été saisies la tension de batterie attendue en vue d'une opération de démarrage du moteur à combustion interne qui suit à un troisième instant, et
qui compare la tension de batterie attendue au troisième instant à une valeur de seuil prédéterminée pour ainsi en déduire la possibilité de démarrer le moteur à combustion interne.

**8.** Ensemble selon la revendication 7, dans lequel l'unité d'évaluation est conçue pour commander le ou les capteurs de saisie des premières et des deuxièmes valeurs de paramètres de batterie au premier et au deuxième instant.

# FIG 1

# FIG 2

22

21

| Elektrisches Modell des Anlassers | Schalter | $R^1_{Batterie}$ | $R^2_{Batterie}$ | Elektrisches Modell der Batterie |

$R_{Anlasser}$

$M_{Anlasser}$

$V_{Batterie}$

$C^1_{Batterie}$

$C^2_{Batterie}$

$V^0_{Batterie}$

# FIG 3

Batteriespannung

t0 t1

t1a

Zeit

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080215266 A